# EUROPÄISCHE PATENTSCHRIFT

(11) **EP 3 708 340 B1**
(45) Veröffentlichungstag und Bekanntmachung des Hinweises auf die Patenterteilung: **14.12.2022**
(21) Anmeldenummer: 19161827.1
(22) Anmeldetag: 11.03.2019
(51) Int. Cl.: B29C 64/386, B33Y 50/00, G05B 19/4099, B22F 10/30, B33Y 50/02

(54) **PLAUSIBILITÄTSPRÜFUNGSVERFAHREN FÜR ADDITIVE HERSTELLVERFAHREN, INSBESONDERE RAPID-PROTOTYPING-GERÄTE**
PLAUSIBILITY TESTING METHOD FOR ADDITIVE PRODUCTION METHOD, IN PARTICULAR RAPID PROTOTYPING DEVICES
PROCÉDÉ DE VÉRIFICATION DE LA PLAUSIBILITÉ POUR PROCÉDÉS DE FABRICATION ADDITIVE, EN PARTICULIER APPAREILS DE PROTOTYPAGE RAPIDE

(43) Veröffentlichungstag der Anmeldung: 16.09.2020
(60) Teilanmeldung: 22203754.1
(73) Patentinhaber: Ivoclar Vivadent AG, 9494 Schaan (LI)
(72) Erfinder: Ebert, Jörg, 9470 Buchs (CH); Brotzge, Michael, 6842 Koblach (AT)
(74) Vertreter: Baronetzky, Klaus

(56) Entgegenhaltungen:
- EP-A1- 2 926 982
- EP-A1- 3 525 117
- US-A1- 2016 271 883
- MARCO LIVESU ET AL: "From 3D models to 3D prints: an overview of the processing pipeline", COMPUTER GRAPHICS FORUM, Bd. 36, Nr. 2, 23. Mai 2017 (2017-05-23), Seiten 537-564, XP055393619, GB ISSN: 0167-7055, DOI: 10.1111/cgf.13147

## Beschreibung

von Anspruch 1. Eine Druckbarkeitssprüfung ist aus EP 3525117 bekannt, unter Artikel 54(3) EPÜ zitiert. Auch EP 2926982 befasst sich mit Druckbarkeit in einem additiven Herstellungsvorgang. Bei der Realisierung von zu druckenden Objekten wie Dentalrestaurationsteilen in Stereolithographievorrichtungen ist es erforderlich, zunächst per CAM-Software Daten bereitzustellen, die der Stereolithographievorrichtung zugeführt werden sollen.

Die CAM-Software stellt die Daten bereit, mit denen die Stereolithographievorrichtung das zu druckende Objekt per 3D-Druck herstellt.

Dies gilt sinngemäß auch für andere additive Herstellvorrichtungen, insbesondere solche, die schichtweise arbeiten. Besonders herauszustellen sind Laminated Object Modelling, Multi Jet Modeling, Selektives Laserschmelzen, Selektives Lasersintern, Space Puzzle Molding, Stereolithografie, Binder Jetting, und alle übrigen 3D-Druckverfahren.

Nachdem es sich bei der Konstruktion um eine dreidimensionale Realisierung der Form handelt, und nachdem teilweise auch recht komplexe Objekte entworfen und hergestellt werden können, ist es teilweise erforderlich, sogenannte Supportstrukturen zu verwenden. Diese dienen dazu, eine Verbindung zwischen der Nullebene, also der Druckbasis, und dem Objekt bereitzustellen.

Typischerweise erstellt die CAM-Software die Supportstrukturen automatisch.

Es ist jedoch in vielen Fällen möglich, auch ohne Supportstrukturen auszukommen, so dass der Aufwand der Säuberung im späteren Verfahrensablauf deutlich reduziert wird. Hierzu wird das Objekt in die hierfür optimale virtuelle Bauebene gedreht, dergestalt, dass ein vollflächiger Kontakt mit der Nullebene besteht.

Während der Datenvorbereitung in der CAM-Software oder ggf. bereits beim CAD-Design werden häufig Änderungen vorgenommen, aus unterschiedlichen Gründen, die zur Verschiebung oder Verdrehung von Objekten im virtuellen 3D-Bauraum führen.

Gerade bei supportstrukturfreien Konstruktionen führt dies häufig dazu, dass der Kontakt zwischen einer großen und ebenen Außenfläche und der Nullebene nicht mehr oder nicht mehr vollständig gegeben ist.

Eine solche Verdrehung führt zwar nicht zu fehlerhaften Daten, denn der Datenoutput gibt dann nach wie vor das zu druckende Objekt exakt wieder, aber zu möglichen Problemen beim Stereolithographie-Druckprozess.

Des Weiteren besteht die Gefahr, dass während des Stereolithographie-Prozesses oder einem anderen additiven Herstellverfahren aus ähnlichen Gründen von einem Slice zum nächsten, also von einer Schicht zur nächsten, neue Flächen entstehen, die nicht von einer Supportstruktur unterstützt werden. Solche Neuflächen haben keine Verbindung mit dem Objekt und können daher nicht mittels Stereolithographie aufgebaut werden.

Diese Probleme sind bei der Stereolithographie an sich seit langem bekannt. Um ihnen zu begegnen, wird in der CAM-Software teilweise automatisch und teilweise halbautomatisch vorgegeben, zusätzliche Supportstrukturen zu realisieren, auch wenn dies bei einem Aufbau ohne Orientierungsfehler überflüssig wäre.

Derartige Supportstrukturen müssen aber später entfernt werden, und manchmal sitzen die Supportstrukturen dann an Stellen, an denen eine besonders gute Oberfläche erwünscht wäre, was die Anwendbarkeit der Stereolithographie stark beeinträchtigt.

Demgegenüber liegt der Erfindung die Aufgabe zugrunde, ein Plausibilitätsprüfungsverfahren für additive Herstellvorrichtungen wie Rapid-Prototyping-Geräte, insbesondere Stereolithographievorrichtungen, gemäß dem Oberbegriff der Ansprüche 1, 2, 12 bzw. 14 zu schaffen, das qualitativ hochwertige Oberflächen an weiteren Bereichen des erzeugten Objekts ermöglicht, als es bislang möglich war. Diese Aufgabe wird erfindungsgemäß durch Anspruch 1 gelöst.

Vorteilhafte Weiterbildungen ergeben sich aus des Unteransprüchen. Erfindungsgemäß ist es vorgesehen, dass in den Plausibilitätsprüfungsverfahren für Rapid-Prototyping-Geräte die Ausgangsdaten der CAM-Software als Eingangsdaten für die Prüfung verwendet werden.

Die Eingangsdaten werden dergestalt geprüft, dass zunächst die Daten einer Schicht aufgenommen und abgespeichert werden, und dann die Daten einer darauffolgenden Schicht. Es wird dann kurzerhand basierend auf diesen Daten die Summe aller zu belichtender Pixel ermittelt und mit der Summe der zu belichtenden Pixel der folgenden Schichten verglichen.

Wenn die Pixelsumme der folgenden Schicht um einen vorgegebenen Faktor größer als bei der vorherigen Schicht ist, wird ein Signal ausgegeben. Das Signal kann als Warnsignal oder als Fehlersignal realisiert sein. Es wird entweder - beim Warnsignal - eine Warnung angezeigt, oder es wird - beim Fehlersignal - ein Fehlerfall festgestellt und die weitere Ausführung abgebrochen. Der vorgegebene Faktor kann ein beliebiger zu wählender Faktor sein, der größer als 1 ist, beispielsweise 1,3, 1,5, 1,8, 2,5, 3 oder 4.

Welcher Faktor bevorzugt ist, hängt auch von dem verwendeten Druckmaterial ab. Ein Faktor 2 der Pixelsumme bedeutet eine doppelt so große Belichtungsfläche der folgenden Schicht gegenüber der vorherigen Schicht. Eine solche starke Zunahme kann kritisch sein und weist jedenfalls auf eine fehlerhafte Orientierung hin. Im Sonderfall ist die verkippte Orientierung. Diese kann dazu führen, dass bei der Nullebene keine Pixel gedruckt werden müssten, oder eine ganz geringe Pixelanzahl wie z.B. weniger als 5 oder weniger als 20. Die folgende Schicht oder eine der folgenden Schichten hat dann eine Pixelfläche, die ungleich Null ist und daher insofern um mehr als den vorgegebenen Faktor größer ist.

In diesem Fall wird insofern ein Fehlersignal abgegeben, und es ist beabsichtigt, dass der Benutzer den Druck nicht fortsetzt bzw. gar nicht startet, sondern mittels der CAM-Software die erforderlichen Korrekturen vornimmt, also beispielsweise die Orientierungsfehler beseitigt.

Bei den standardmäßig zu druckende Objekten mit einer großen ebenen Außenfläche erstreckt sich diese parallel zur Nullebene. Dann ändert sich die Anzahl der Pixel von Schicht zu Schicht wenig oder gegebenenfalls gar nicht oder nimmt ab. In diesem Fall liegt kein Fehlerfall vor, und es wird kein Warnsignal abgegeben.

Zwar könnte theoretisch von einer Schicht zur nächsten Schicht die Pixelzahl reduziert und an einer anderen Region in dieser Schicht in gleichem Ausmass erhöht sein. Interne Versuche der Anmelderin haben jedoch ergeben, dass dieser Sonderfall praktisch nie auftritt, so dass überraschend mit den erfindungsgemäßen Kriterium eine gute Entscheidungsgrundlage getroffen wird, supportstrukturarme oder supportstrukturfreie 3D-Druckobjekte zu erzeugen, die dementsprechend ohne besondere Nacharbeitung von Oberflächen auskommen und daher eine gute Oberflächengüte haben.

Ausnahmen wären höchstens gegeben in Form von z. B. ausladenden Kiefermodellen oder geometrischen Strukturen z.B. in Form von Artikulationselementen oder beliebig in der Datenvorbereitung definierbaren Basisstrukturen, welche mit dem dentalen Objekt verschmolzen werden, wie z. B. angewinkelte Basen zur einfacheren Entnahme von der Bauplattform oder Kanalstrukturen. Während die Zunahme der Belichtungsfläche in letzteren Fällen theoretisch als Metainformation der Datenvorbereitung mitgeliefert und berücksichtigt werden kann, ist der dentale Fall ein Beispiel für einen höheren Faktor (dennoch < 2).

Zur konstruktiven Abdeckung derartiger Ausnahmen ist es in einer besonderen Ausführungsform der Erfindung vorgesehen, dass die gesamte Fläche in Teilregionen unterteilt wird. Als Teilregion wird eine solche Fläche bestimmt, die in einer betrachteten Schicht eine Vielzahl zu belichtender Pixel aufweist.

Zwei aufeinanderfolgende Schichten wird erfindungsgemäß geprüft und es wird die Summe aller zu belichtender Pixel innerhalb einer ersten Teilregion dieser Schicht ermittelt. Es wird ein Signal ausgegeben, wenn die Pixelsumme, also die Belichtungsfläche innerhalb einer zweiten Teilregion einer der folgenden Schichten sich zumindest um einen vorgegebenen Faktor von der Anzahl der Pixel in der ersten, mit der zweiten verbundenen, Teilregion der vorherigen Schicht unterscheidet, insbesondere mindestens um den vorgegebene Faktor größer ist.

Unter verbundenen Teilregionen ist hier zu verstehen, dass die zu belichtenden Teilregionen einander benachbarter Schichten Pixel haben, die aneinander anliegen, also, dass sie mindestens einen gemeinsamen zu belichtenden Bildpunkt (Pixel) haben, also eine solchen mit den gleichen x- und y-Koordinaten.

Wenn die zu erzeugenden Objekte mit Supportstrukturen erzeugt werden, ist es gemäß einem weiteren Aspekt der Erfindung vorgesehen, dass ein Vergleich der Pixel einer Schicht mit den Pixeln der nächsten Schicht dahingehend erfolgt, ob in der nächsten Schicht eine nicht verbundene Bauteilregion von zu druckenden Pixeln besteht, die in der vorherigen Schicht noch nicht vorhanden war. In einem solchem Falle wird ebenfalls ein Signal abgegeben, und gewarnt, dass Supportstrukturen fehlen.

Gemäß einem weiteren Aspekt der Erfindung, der auch greift, wenn die zu erzeugenden Objekte mit Supportstrukturen erzeugt werden, erfolgt ein Vergleich der Anzahl der Pixel einer Schicht in der Supportstruktur mit der Anzahl der Pixel der nächsten Schicht in der Supportstruktur.

Dieser Vergleich wird Schicht für Schicht wiederholt, und ein Signal wird abgegeben, wenn das Ergebniss der Vergleiche ergibt, dass über eine vorgegebene Zahl von Schichten kein Flächenzuwachs erfolgt, der ein vorgegebenes Mass übersteigt.

Dies bedeutet dann, dass die längliche, stabförmige Supportstruktur vertikal zu lang geworden ist, um ungestützt die gewünschte Stützfunktion realisieren zu können. Es wird eine Verzweigung oder eine Gitterstruktur von Supportstäben erforderlich.

Das Signal kann diesen Fehlerfall anzeigen.

Das Signal kann entweder die Einleitung des Druckvorgangs automatisch stoppen, oder es wird ein Warnsignal abgegeben. Dieses Warnsignal kann akustisch oder optisch signalisieren, dass ein Baufehler zu erwarten ist.

Zusätzlich ist es zweckmäßig, Hinweise zu geben, was der Nutzer als nächstes tun sollte, nämlich, den Orientierungsfehler in der CAM-Software zu beseitigen. Wenn sich bei der Überprüfung der Schichten herausstellt, dass es im Bereich von beliebigen aufeinanderfolgenden Schichten zu einer Neufläche kommt, also eine nicht verbundene und neu entstehende Bauteilregion oder gleichsam einer Insel von Pixeln, die bei der vorherigen Schicht noch nicht vorhanden war, wird ebenfalls ein entsprechendes Warnsignal abgegeben. Hier kann die Warnmeldung dahingehend modifiziert werden, dass die Supportstrukturen in der CAM-Software überprüft werden sollten.

Erfindungsgemäß günstig ist die Absicherung, dass der Baujob ohne Fehler durchgeführt werden kann. Ferner, einen sichergestellten Baujob zur Verfügung zu stellen, da vorab sicher vermieden wird, dass Verunreinigungen ohne Supportstrukturen ins Baumaterial gelangen könnten.

Ein Mehraufwand aufgrund des zu erwartenden Fehlbaujobs wird vermieden. Der Mehraufwand stellte bislang einen erheblichen wirtschaftlichen Schaden dar (Zeitverlust: Der Fehlbaujob muss beseitigt und wiederholt werden. Verzögerungen beim Kunden. Finanzieller Verlust: Materialverlust von Baumaterial und ggfs. Verbrauchsartikeln.)

Es versteht sich, dass gemäß dem erfindungsgemäßen Pausibilitätsprüfungsverfahren zunächst sämtliche Schichten, also sämtliche Daten der CAM-Software, überprüft werden, bevor der Druck freigegeben wird. Insofern startet der Baujob nicht, wenn ein entsprechendes Warnsignal abgegeben wird.

In vorteilhafter Ausgestaltung wird der Unterschied zwischen der Pixelanzahl von aufeinanderfolgenden Schichten überwacht, bevorzugt kontinuierlich, und es wird ein Signal abgegeben wird, wenn der prozentuale Unterschied der Pixelzahlen größer als ein vorgegebener Wert, größer als ein positiver Wert oder kleiner als ein negativer Wert ist.

Wenn kein Fehlerfall auftritt, entsprechen die Ausgangsdaten den Eingangsdaten, und der 3D-Druck erfolgt in an sich bekannter Weise.

Während erfindungsgemäß zwei aufeinanderfolgende Schichten geprüft werden und die Änderung zwischen diesen erfasst wird, hinsichtlich der Anzahl der zu belichtenden Pixel, ist es auch möglich, in einer Art Historie mehr als die vorhergehende Schicht für die Überwachung einzubeziehen. So ist es möglich, einen etwaigen Fehlerfall noch feinfühliger zu erfassen.

Wenn die Anzahl der belichteten Pixel aufeinanderfolgender Schichten prozentual um mehr als einen vorgegebenen Wert zunimmt, beispielsweise um 2%, kann das Signal abgegeben werden, wobei es auch möglich ist, die Signalisierung dann vorzunehmen, wenn die Pixelanzahl bei aufeinanderfolgenden Schichten sich um den entsprechenden Faktor nach unten unterscheidet, die Pixelanzahl sich also vermindert.

In vorteilhafter Ausgestaltung ist es vorgesehen, dass erfindungsgemäß das Plausibilitätsprüfungsverfahren in einem Druckertreiber der Stereolithographievorrichtung zu realisieren. Es versteht sich, dass bei Bedarf aber anstelle dessen auch ein separates Modul realisiert werden kann, das das erfindungsgemäß durchführt, und es ist auch möglich, einen zentralen Server oder eine Cloud für solche Zwecke zu verwenden.

Weitere Vorteile, Einzelheiten und Merkmale ergeben sich aus den nachfolgenden Beschreibungen eines Ausführungsbeispiels der Erfindung anhand der Zeichnung.

Es zeigen:
- Fig. 1: eine schematische Ansicht der belichteten Pixel der Schichten eines zu erstellenden Objekts, dargestellt in verschiedenen Schichten, nämlich den Schichten 1, 2, 12, 22, 32, 42;
- Fig. 2: eine Darstellung der belichteten Pixel eines anderen Objekts, unter Darstellung der Schichten 3 und 4;
- Fig. 3: eine Darstellung der Anzahl der Pixel des Objekts genäß Fig. 1, über die Schichten von 0 bis 500, und zwar sowohl bei einer verkippten Orientierung als auch bei paralleler Orientierung;
- Fig. 4: eine Darstellung der ersten 45 Schichten in dem Diagramm gemäß Fig. 3, wiederum sowohl bei der verkippten Orientierung als auch bei der parallelen Orientierung;
- Fig. 5: eine Darstellung der prozentualen Zunahme bw. Abnahme der Belichtungsfläche von Schicht zu Schicht, über die ersten 100 Schichten, wobei wiederum die parallele Orientierung und auch die verkippte Orientierung dargestellt sind;
- Fig. 6: eine schematische Darstellung der Einheiten für ein erfindungsgemäßen Plausibilitätsprüfungsverfahren; und
- Fig. 7: eine schematische Darstellung einer Supportstruktur zur Verdeutlichung des Fehlerfalls gemäß Anspruch 14;
- Fig. 8: eine schematische Darstellung einer weiteren Ausführungsform einer Supportstruktur zur Verdeutlichung des Fehlerfalls gemäß Anspruch 14; und
- Fig. 9: eine schematische Darstellung einer weiteren Ausführungsform einer Supportstruktur zur Verdeutlichung des Fehlerfalls gemäß Anspruch 14.

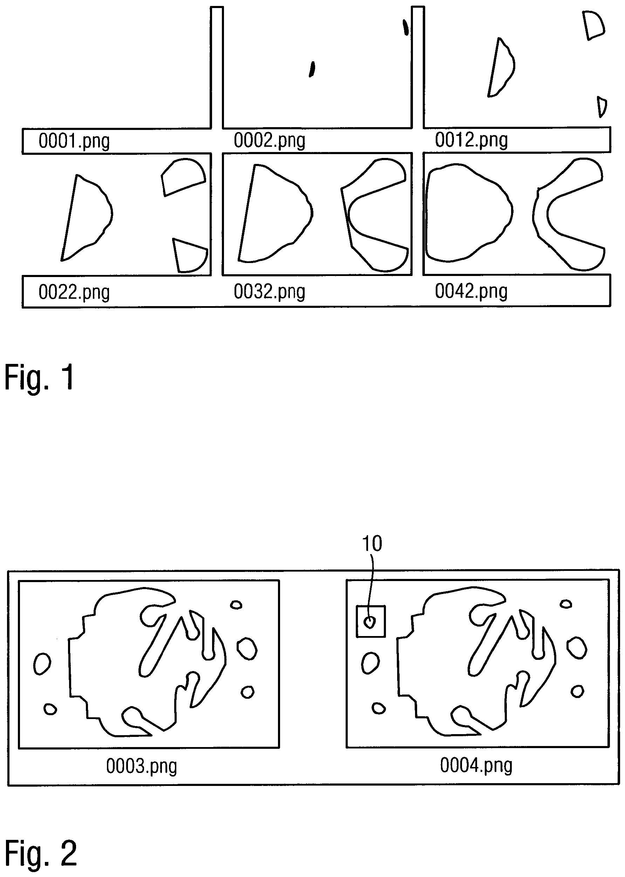

Das erfindungsgemäße Verfahren wird anhand der Figuren, insbesondere zunächst der Fig. 1, 3 und 4, näher beschrieben.

In Fig. 1 sind 6 verschiedene Bilder von belichteten Pixeln dargestellt, entsprechend den jeweiligen Schichten 1, 2, 12, 22, 32 und 42. Diese bilden die Grafikdaten und sind je mittels der CAM-Software erzeugt.

Gemäß Fig. 1 ist die Schicht 0001.png frei von belichteten Pixeln.

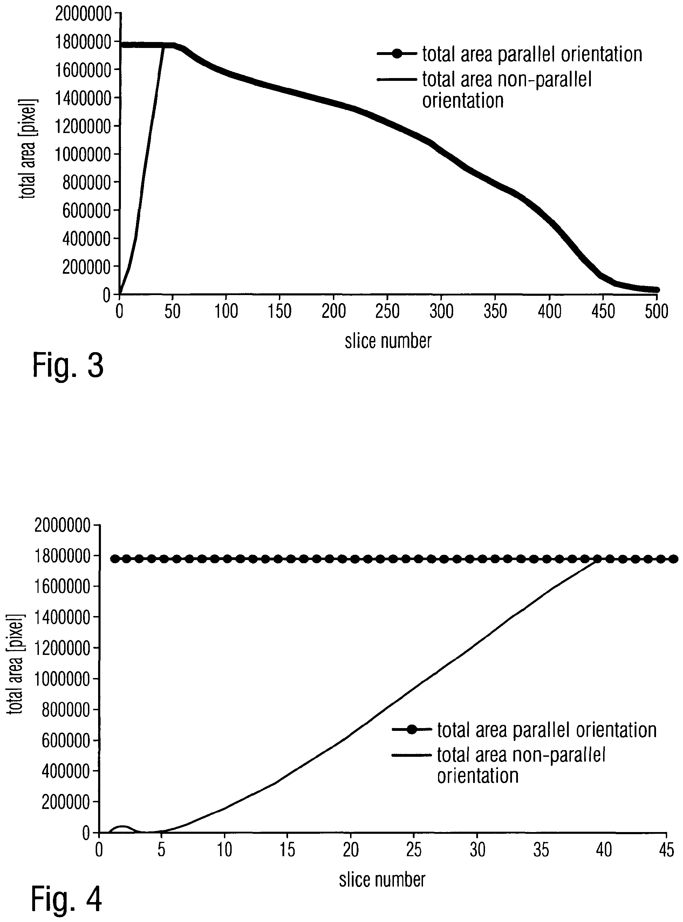

Dies lässt sich im Grunde auch Fig. 4 entnehmen. Die dortige durchgezogene und graue Kurve zeigt bei der Schicht Nr. 1, dort als Slice Number 1 bezeichnet, einen geringen Wert nahe Null, oder ggf. genau Null.

In den Fig. 3 und 4 ist die Gesamtanzahl der belichteten Pixel als "total area [Pixel]" über der Nummer der betreffenden Schicht ("slice number") aufgetragen. Es sind je die Kurven für eine zutreffende Orientierung und für eine fehlerhafte Orientierung aufgetragen, in Fig. 3 die Gesamtfläche mit paralleler Orientierung ("total area parallel orientation") als dicke schwarze Linie und in Fig. 4 als schwarze Linie mit Kreisen, und in beiden Fig. 3 und 4 die Kurve bei fehlerhafte Orientierung als graue Linie, bezeichnet als "total area non-parallel orientation".

Fig. 3 ist auf der Abszisse die Gesamtanzahl von Schichten aufgetragen, also 500, während der Maßstab in Fig. 4 so gewählt ist, dass lediglich die Schichten 1 bis 45 aufgetragen sind.

Im Beispielfall beträgt die Schichtdicke jeder Schicht 50µm, wobei es sich versteht, dass das Verfahren sinngemäß bei jeder beliebigen Schichtdicke anwendbar ist.

Auch wenn in Fig. 1 bei "0001.png" keine Pixel zu ersehen sind, sind tatsächlich 10 Pixel vorhanden. In der nächstfolgenden Schicht, hier als Schicht "0002.png" bezeichnet, beträgt die Gesamtanzahl der Pixel 8726.

Das erfindungsgemäße Plausibilitätsprüfungsverfahren prüft nun das Verhältnis der belichteten Pixel zwischen aufeinanderfolgenden Schichten, hier also den Schichten "0001.png" und "0002.png". Das Verhältnis beträgt dementsprechend 827,6 : 1, berechnet aus den Pixelanzahlen 8726 und 10.

Es ist jedenfalls deutlich größer als ein vorgegebener Wert, der hier mit dem Faktor 2 angesetzt ist, und es wird erfindungsgemäss ein Signal abgegeben, das ein Fehlerfall anzeigt. In diesem Fall liegt ein Baufehler vor, da das 3D-Objekt bei der CAD-Verarbeitung versehentlich gekippt wurde, so dass es nicht mit einer ebenen Außenfläche an der Nullebene oder der Basis anliegt, sondern eben nur mit 10 Pixeln.

Hier wird nun die weitere Überprüfung beschrieben, auch wenn das erfindungsgemäße Verfahren bereits an dieser Stelle dazu führt, dass der Druckjob unterbrochen wird und der Benutzer gebeten wird, die Orientierung des Objektes oder der Objekte in der CAM-Software zu korrigieren.

In dem Fall, dass die Anzahl der Pixel der ersten Schicht geringer als ein vorgegebener Wert ist, beispielsweise 100, kann bei Bedarf eine zusätzliche Fehlermeldung ausgegeben werden, beispielsweise ebenfalls dahingehend, dass eine ebene Auflage auf der Nullebene des Bauraums nicht gegeben sei.

Aus Fig. 3 und Fig. 4 ist ersichtlich, dass hingegen bei paralleler Orientierung die Anzahl der zu belichtenden Pixel bei den ersten 45 Schichten knapp 1,8 Mio. beträgt. Diese Orientierung ist eine baubare Orientierung; die CAM-Software hat die parallele Orientierung entsprechend den Benutzereingaben realisiert.

Die Schicht 3 entsprechend "0003.png" hat eine Pixelanzahl von 24565. Hier würde wiederum der Quotient aus der Anzahl der belichteten Pixeln der Schichten 3 und 2 gebildet, und es ergäbe sich ein Wert, der etwa 3 beträgt und jedenfalls größer als 2 ist.

Auch hier würde - wenn die Fehlerabfrage bis dahin durchdringen würde - ein Fehler angezeigt.

Die Schichten 12, entsprechend "0012.png", 22, entsprechend "0022.png", 32, entsprechend "0032.png" und 42, entsprechend "0042.png" sind ebenfalls, wie aus Fig. 1 ersichtlich, hier dargestellt und zeigen, dass die Baufläche entsprechend der Anzahl der belichteten Pixel deutlich zunimmt. Die relative Zunahme der Pixelanzahl pro Schicht ist jedoch unter dem Faktor 2, wobei die Pixelzunahme auf 10 Schichten betrachtet relativ immer stärker abnimmt.

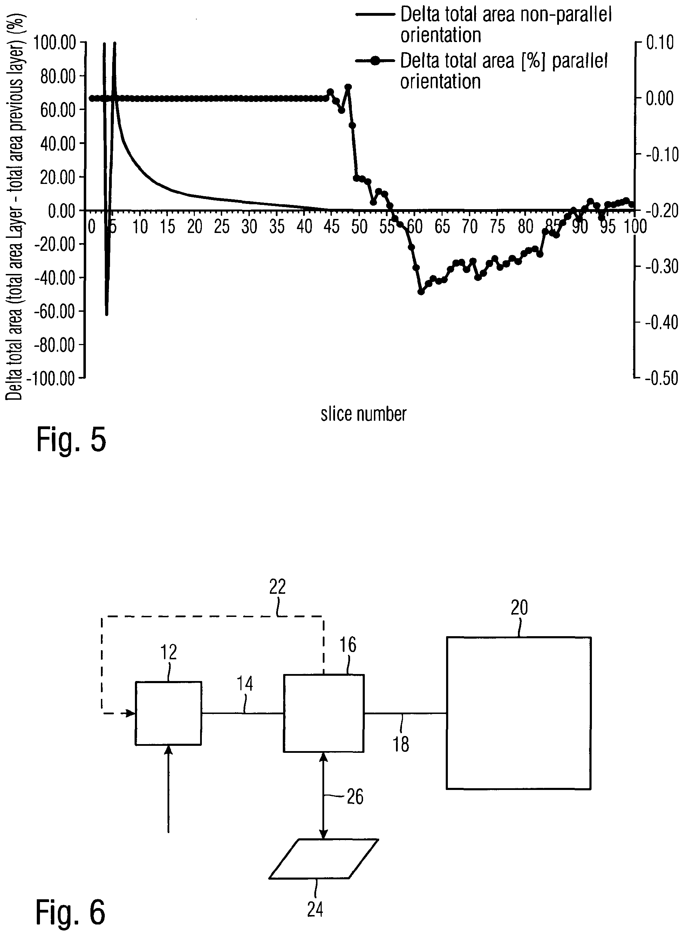

Erfindungsgemäß ist es günstig, wenn die relative Zunahme der Pixelanzahl geprüft wird. Dies ist aus Fig. 5 ersichtlich. Die Art der Kurven entsprechen den Kurven aus den Fig. 3 und 4. Es ist jeweils das Delta, also der Unterschied der Gesamtfläche, als "delta total area" bezeichnet, also die Zunahme oder Abnahme der Anzahl der belichteten Pixel gegenüber der der vorherigen Schicht.

Betrachtet man zunächst den Fehlerfall, ist aus Fig. 4 ersichtlich, dass die Pixelanzahl bei Schicht 3 von Null verschieden ist und bei Schicht 4 auch nur abnimmt, und bei Schicht 5 jedoch wiederum von Null verschieden ist.

Dies kommt in der grauen Kurve, gemäß Fig. 5 zum Ausdruck, wobei bei Schicht 4 das Delta negativ ist, da eine Abnahme der Pixelanzahl zwischen Schicht 3 und Schicht 4 vorliegt.

Letztlich ist die graue Kurve gemäß Fig. 5 das Differential der grauen Kurve aus Fig. 4.

Die schwarze Kurve in Fig. 5 zeigt die Abweichung, also das Delta, der schwarzen Kurve aus Fig. 4 im Nicht-Fehlerfall. Die ersten 100 Schichten sind an einer rechts dargestellten Sekundärachse oder Sekundärabszisse in hoher Auflösung aufgetragen.

Wie ersichtlich ist, ist das Delta von Schicht zu Schicht gering, weniger als +/- 0,4 %, also im Betrag weniger als 0,4%

Die nachstehende Tabelle gibt das Delta für die Schichten 1 bis 10 numerisch wieder; bei Schicht 2 findet sich dementsprechend der Wert 87160%, etwa entsprechend dem Faktor 872,6 gemäß der vorstehenden Beschreibung.

**Tabelle: Delta der im Bild vorhandenen Pixel im Verhältnis zur Anzahl im vorherigen Bild, in Prozent.**

| slice number =Schichtnummer | Delta total area [%], parallel orientation= Delta Gesamtfäche gegen vorherige Schicht, in %, parallele Orientierung | Delta total area [%], non-parallel orientation= Delta Gesamtfäche gegen vorherige Schicht, in %, gekippte Orientierung |
|---|---|---|
| 1 | | |
| 2 | 0.00 | 87160.00 |
| 3 | 0.00 | 181.52 |
| 4 | 0.00 | -64.46 |
| 5 | 0.00 | 181.39 |
| 6 | 0.00 | 80.03 |
| 7 | 0.00 | 54.88 |
| 8 | 0.00 | 40.33 |
| 9 | 0.00 | 34.33 |
| 10 | 0.00 | 28.96 |
| 11 | 0.00 | 24.66 |
| 12 | 0.00 | 21.08 |
| 13 | 0.00 | 18.23 |
| 14 | 0.00 | 16.31 |
| 15 | 0.00 | 14.34 |
| 16 | 0.00 | 13.11 |
| 17 | 0.00 | 11.80 |
| 18 | 0.00 | 10.83 |
| 19 | 0.00 | 9.88 |
| 20 | 0.00 | 9.32 |

Es versteht sich, dass der Schwellwert, ab dem ein Signal abgebbar ist, in weiten Bereichen anpassbar ist. Entsprechend dem Verlauf der grauen Kurven in den Figuren 4 und 5 sinkt das Delta mit zunehmender Schichtnummer.

Aus Fig. 2 ist ersichtlich, in welcher Weise gemäß einer weiteren Ausgestaltung der Erfindung ein Baujob für Objekte mit Supportstrukturen überprüft wird. Hier sind die Schichten 3 und 4 entsprechend "0003.png" und "0004.png" dargestellt. Der Vergleich der beiden Belichtungsbilder ergibt, dass eine neue Bauregion oder Insel 10 bei Schicht 4 neu auftritt. Das Verhältnis der belichteten Pixel wäre bei diesem Ausführungsbeispiel jedoch nicht so, dass ein Fehlersignal gemäß der vorstehenden Überprüfung abgegeben würde. Jedoch wird die nicht verbundene Bauteilregion oder Insel 10 als neue Fläche im freien Raum realisiert, und eine entsprechende Schichtentwicklung würde dazu führen, dass ein neues Objekt ohne Bindung an die Bauplattform und das Objekt im Übrigen entstehen würde, das dementsprechend in der Druckflüssigkeit sich gegebenenfalls frei bewegen könnte oder gegebenenfalls auch an einer falschen Stelle fixiert würde.

Auch dieser Fehlerfall wird erfindungsgemäß abgedeckt, und es wird dem Benutzer empfohlen, eine Supportstruktur in der CAM-Software für die nicht verbundene Bauteilregion 10 neu einzufügen bzw. das Bauteil entsprechend neu auszurichten.

Aus Fig. 6 ist ein Schaubild ersichtlich, das die einzelnen Schritte und Einheiten für das erfindungsgemäße Verfahren symbolisieren soll. Ein CAM-Software-Modul 12 erstellt per Benutzereingriff die Eingangsdaten 14, die einem Plausibilitätsprüfungsmodul 16 zugeleitet werden. Das Plausibilitätsprüfungsmodul 16 gibt Ausgangsdaten 18 aus, die als Daten für die Speisung des Stereolithographievorrichtung 20 dienen.

Die Ausgangsdaten 18 werden jedoch nur dann direkt abgegeben, wenn die Plausibilitätsprüfung erfolgreich war, also kein Signal abgegeben wird. Die Übermittlung der Ausgangsdaten wird unterbunden, bis der Anwender die Warnmeldung zur Kenntnis genommen und die weitere Bearbeitung freigegeben hat oder dem Warnhinweis folgt.

Das Signal 22 wird dann abgegeben, wenn entweder die Anzahl der belichteten Pixel zwischen aufeinanderfolgenden Schichten sich um weniger als einen vorgegebenen Wert unterscheidet, oder durch Vergleich von aufeinanderfolgenden Schichten sich ergibt, dass eine neue Insel 10 in der je betrachteten Schicht gegenüber der vorherigen Schicht aufgetreten ist.

Ein solcher Vergleich lässt sich mit einem handelsüblichen Bildverarbeitungsalgorithmus realisieren.

Das Signal 22 wird im dargestellten Ausführungsbeispiel der CAM-Vorrichtung zugeleitet, und zusätzlich wird eine Anzeigevorrichtung 24 über ein Warnsignal 26 aktiviert, die dem Benutzer darauf hinweist, dass er den Baujob nicht freigeben sollte.

Auch wenn in Fig. 6 lediglich eine Anzeigevorrichtung 24 dargestellt ist, versteht es sich, dass hier eine bidirektionale Kommunikation mit dem Plausibilitätsprüfungsmodul 16 möglich ist, dergestalt, dass der Benutzer dann entscheidet, wie mit dem Baujob im Plausibilitätsprüfungsmodul 16 weiter verfahren werden soll.

Beispielsweise wird der Benutzer dann entsprechend der Empfehlung den Baujob abbrechen und löschen und sich erneut zu den CAM-Softwaremodul 12 begeben, um dort die erforderlichen Korrekturen vorzunehmen.

Es versteht sich, dass der dann korrigierte Baujob erneut dem Plausibilitätsprüfungsmodul 16 zugeleitet wird, so dass die Plausibilitätsprüfung auch zyklisch mehrfach durchlaufen werden kann, bis ein zufriedenstellender Baujob vorliegt, der über die Ausgangsdaten 18 der Stereolithographievorrichtung 20 zugeleitet wird.

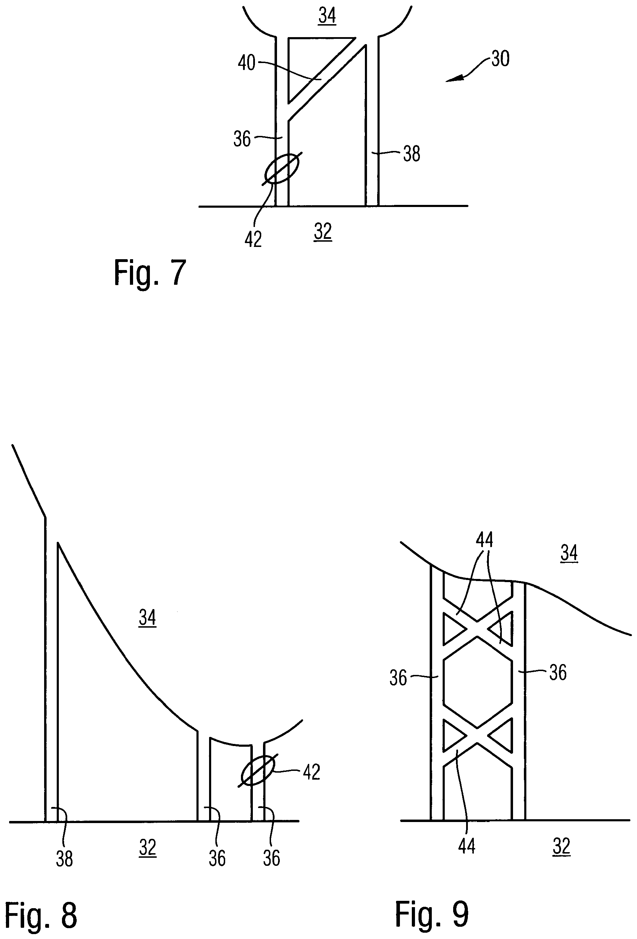

In Fig. 7 sind beispielhafte Supportstrukturen 30 zur Verdeutlichung der Erfindung gemäß Anspruch 14 dargestellt. Diese erstrecken sich zwischen der Basis oder Nullebene 32 und dem Objekt 34.

Beispielhaft ist ein erster Supportstab 36, ein zweiter Supportstab 38 und eine Supportverzweigung 40 dargestellt. Diese liegen virtuell, also als Eingangsdaten 14 an dem Plasuibilitätsprüfungsmodul 16 an.

Jede Supportstrukur 30 ist gesliced, besteht also aus Schichten, im Beispielsfall mit einer Schichtstärke von 50 µm.

Von der Basis 32 zur Verzweigung 40 hat der Supportstab 36 300 Schichten, also eine Länge von 15 mm.

Bei dem verwendeten Druckmaterial kann er diese Länge haben, ohne dass eine Querabstützung erforderlich wäre, und denn den erwünschten Support bieten.

Die Länge des Stabes 36 zwischen der Verzweigung 40 und dem Objekt 34 beträgt 250 Schichten oder 12,5 mm.

Die Querschnittsfläche 42 oder die Anzahl der Pixel pro Schicht beträgt bei dem Stab 36, und zwar sowohl unterhalb also auch oberhalb der Verzweigung, um 450 , mit
einer Schwankungsbreite von +/- 50. Dies entspricht einem Durchmesser von etwa 1,2 mm.

Bei dem Stab 38 beträgt die Pixelanzahl pro Schicht ebenfalls zwischen 400 und 500.

Da er nicht von einer Verzweigung seitlich gestützt wird, ist die ungestützte Länge jedoch wesentlich größer als beim Stab 36 und beträgt 600 Schichten oder 30 mm.

Diese Länge sei zu groß, um noch eine sichere Abstützung zu ermöglichen.

Erfindungsgemäß wird für den Stab 38 daher ein Fehler-Signal abgegeben. Die Anzahl der Pixel pro Schicht ändert sich über 400 Schichten betrachtet bei Stab 36 signifikant, aufgrund der Verzweigung 40 bzw. aufgrund des Objektes 34, bleibt jedoch bei Stab 38 innerhalb von 400 bis 500.

Bei diesem Ausführungsbeispiel beträgt die Zahl der aufeinanderfolgenden Schichten, bei denen keine Flächenzunahme erforderlich ist, um das Signal zu vermeiden, 400. Die vorgegebene Maß der Flächenzunahme - und damit der Zunahme der Anzahl der Pixel - beträgt 50 %.

An der Verzweigung bei Schicht 300 steigt bei Stab 36 die Pixelanzahl auf 750. Dies reicht, um den Fehlerfall und damit das Signal zu vermeiden - auch wenn bei Schicht 400, also nach der Verzweigung, die Pixelanzahl wieder geringer als 500 ist.

Bei Stab 38 hingegen beträgt bei Schicht 400 die Pixelanzahl immer noch - also über seine ganze Länge bis dahin - weniger als 500, so dass dort das Signal ausgelöst wird.

Es versteht sich, dass die angegebenen Werte lediglich beipielhaft sind, je nach Druckmaterial lassen sie sich in weiten Bereichen an die Erfordernisse anpassen.

In Fig. 8 ist eine gegenüber der Ausführungsform in Fig. 7 andere Supportstruktur dargestellt. Die Supportstäbe 36 sind hier wesentlich kürzer und weisen ein Verhältnis der Höhe zum Durchmesser 42 von etwa 6:1 auf.

Bei diesem Verhältnis können die Stäbe 36 als stabil angesehen werden, so dass kein Signal 22 abgegeben wird.

Hingegen weist der Stab 38 ein Höhen/Durchmesser-Verhältnis (HDV) von etwa 25:1 auf.

Das ist für die ausreichende Stabilität zu viel, zumal keine seitliche Abstützung oder Verzweigung besteht. Es wird ein Fehlersignal abgegeben.

In Fig. 9 sind die Stäbe 36 nahezu gleich lang wie der Stab 38 aus Fig. 8. Sie haben ein Höhen/Durchmesser-Verhältnis von etwa 20:1, was ungestützt zu viel wäre.

Bereits im unteren Drittel Ihrer Höhe verzweigen sie sich jedoch in Verstrebungen 44, die seitlich stützend wirken. Damit wird der Fehlerfall vermieden, zumal die frei tragende Länge der Stäbe 36 in Fig. 9 nur bis zu einem HDV von etwa 5:1 geht.

Für die Fehlervermeidung ist insofern entscheidend, ob die frei tragende, also unverzweigte Länge eines Supportstabes ein HDV von mehr als ein vorgegebenes Mass, hier z.B. 8:1, hat.

Dies ist über die Anzahl der Schichten zur Fläche der Supportstruktur (=Pixelanzahl) erfassbar.

Es versteht sich, dass, auch wenn hier 2D-Strukturen dargestellt sind, tatsächlich auch die dritte Dimension berücksichtigt werden muss.

## Patentansprüche

1. PlausibHitätsprüfungsverfahren für additive Hersieilvorrichtungen, mit mittels einer CAM-Software erzeugten Eingangsdaten, die in Form von Grafikdaten vorliegen, die als je zu druckende Schichten wiedergeben werden, wobei jede Schicht mindestens einen Pixel, insbesondere eine Vielzahl von Pixeln aufweist, die der in der betreffenden Schicht zu druckenden Bauteilregion entspricht, und mit Ausgangsdaten, die die additive Herstellvorrichtung ansteuern, um das zu druckende Bauteil herzustellen, **dadurch gekennzeichnet, dass** die Eingangsdaten (14) mindestens zweier aufeinanderfolgender Schichten geprüft werden und für jede Schicht die Summe aller zu belichtender Pixel ermittelt wird, und dass ein Signal (22) ausgegeben wird, wenn die Pixelsumme, also die Belichtungsfläche einer folgenden Schicht sich zumindest um einen vorgegebenen Faktor von der der vorherigen Schicht unterscheidet, insbesondere mindestens um den vorgegebene Faktor größer ist.

2. Verfahren nach Anspruch 1, **dadurch gekennzeichnet, dass** ein Signal (22) ausgegeben wird, wenn die Summe aller belichtenden Pixel der ersten Schicht Null oder kleiner als ein vorgegebener Wert ist.

3. Verfahren nach Anspruch 1 oder 2, **dadurch gekennzeichnet, dass** das Verfahren bei einer additiven Herstellvorrichtung (20) eingesetzt wird und bei unmittelbar, also bei auf der Plattform ohne Supportstruktur, gedruckten Objekten angewendet wird.

4. Verfahren nach einem der vorherigen Ansprüche, **dadurch gekennzeichnet, dass** der Unterschied zwischen der Pixelanzahl von aufeinanderfolgenden Schichten überwacht wird und ein Signal (22) abgegeben wird, wenn der prozentuale Unterschied größer als ein vorgegebener Wert, größer als ein positiver Wert oder kleiner als ein negativer Wert ist.

5. Verfahren nach Anspruch 4. **dadurch gekennzeichnet, dass** der Wert ein Betrag ist

6. Verfahren nach einem der vorherigen Ansprüche, **dadurch gekennzeichnet, dass** die Zunahme und/oder die Abnahme der Pixelanzahl zwischen mindestens zwei bereits geprüften Schichten bei der Entscheidung, ob das Signal abgegeben wird oder nicht, berücksichtigt wird.

7. Verfahren nach einem der vorherigen Ansprüche, **dadurch gekennzeichnet, dass** die Abweichung hinsichtlich der Anzahl der Pixel bei aufeinanderfolgenden Schichten überprüft wird und ein Signal (22) abgegeben wird, wenn die Abweichung einen Sprung ins Negative macht, also sich von einer positiven Abweichung in eine, insbesondere deutlich von Null verschiedene, negative Abweichung ändert.

8. Verfahren nach einem der vorherigen Ansprüche, **dadurch gekennzeichnet, dass** das Signal (22) auf einer Anzeigevorrichtung angezeigt wird und darauf hindeutet, dass ein Baufehler zu erwarten ist und eine andere Orientierung des oder der Objekte und die erneute Einspeisung in die CAM-Software (12) empfohlen wird.

9. Verfahren nach einem der vorherigen Ansprüche, **dadurch gekennzeichnet, dass** die kennzeichnenden Merkmale gemäß Anspruch 1, in einem Algorithmus realisiert sind und der Algorithmus in der Treibersoftware für eine additive Herstellungsvorrichtung (20) realisiert ist.

10. Verfahren nach einem der vorherigen Ansprüche, **dadurch gekennzeichnet, dass** ein Algorithmus, gemäß dem kennzeichnenden Merkmal von Anspruch 1, in der CAM-Software (12) an deren Ausgang oder in einer Cloud realisiert ist.

11. Verfahren nach einem der vorherigen Ansprüche, **dadurch gekennzeichnet, dass** die zu erzeugenden Objekte mit Supportstrukturen erzeugt werden und ein Vergleich der Pixel einer Schicht mit den Pixeln der nächsten Schicht dahingehend erfolgt, ob in der nächsten Schicht eine nicht verbundene Bauteilregion von zu druckenden Pixeln besteht, die in der vorherigen Schicht noch nicht vorhanden war und dass in solchem Falle ein Signal (22) abgegeben wird.

12. Verfahren nach Anspruch 11, **dadurch gekennzeichnet, dass** bei Erzeugung des Signals (22) auf einer Anzeigevorrichtung eine Warnung hinsichtlich fehlender Supportstrukturen abgegeben wird.

13. Verfahren nach einem der Ansprüche 1 bis 10, **dadurch gekennzeichnet, dass** die zu erzeugenden Objekte mit Supportstrukturen erzeugt werden und ein Vergleich der Anzahl der Pixel einer Schicht in der Supportstruktur mit der Anzahl der Pixel der vorherigen Schicht und der vorherigen Schichten in der Supportstruktur erfolgt, und dass ein Signal abgegeben wird, wenn das Ergebnis der Vergleiche ergibt, dass über eine vorgegebene Zahl von Schichten keine Zunahme der Anzahl der Pixel pro Schicht, und damit kein Flächenzuwachs erfolgt, die bzw. der ein vorgegebenes Maß übersteigt.

## Claims

1. A method for checking plausibility for additive manufacturing devices, comprising input data produced by CAM software, said input data being in the form of graphics data which is rendered as layers to be printed, respectively, every layer having at least one pixel, in particular a plurality of pixels, corresponding to the component region to be printed in the concerned layer, and output data controlling the additive manufacturing device to produce the component to be printed, **characterized in that** the input data (14) of at least two consecutive layers is checked and for every layer the sum of all pixels to be exposed is determined, and **in that** a signal (22) is output when the pixel sum, i.e. the exposure area of a subsequent layer, differs from that of the previous layer at least by a predetermined factor, in particular is larger at least by the predetermined factor.

2. The method according to claim 1, **characterized in that** a signal (22) is output when the sum of all pixels to be exposed of the first layer is zero or smaller than a predetermined value.

3. The method according to claim 1 or 2, **characterized in that** the method is used in an additive manufacturing device (20) and is applied to objects directly printed on the platform, i.e. without a support structure.

4. The method according to one of the previous claims, **characterized in that** the difference between the number of pixels of consecutive layers is monitored and a signal (22) is output when the difference in percentage terms is larger than a predetermined value, larger than a positive value or smaller than a negative value.

5. The method according to claim 4, **characterized in that** the value is an absolute value.

6. The method according to one of the previous claims, **characterized in that** increase and/or decrease in the number of pixels between at least two layers which have already been checked is considered with regard to a decision if the signal is output or not.

7. The method according to one of the previous claims, **characterized in that** the deviation with regard to the number of pixels in consecutive layers is checked and a signal (22) is output when the deviation switches to negative, i.e. the deviation changes from a positive deviation to a negative deviation, which in particular clearly differs from zero.

8. The method according to one of the previous claims, **characterized in that** the signal (22) is displayed on a display device and indicates that a construction error is expected, and another orientation of the one or more objects and renewed feeding into the CAM software (12) is recommended.

9. The method according to one of the previous claims, **characterized in that** the characteristic features according to claim 1 are realized in an algorithm and the algorithm is realized in the driver software for an additive manufacturing device (20).

10. The method according to one of the previous claims, **characterized in that** an algorithm according to the characteristic feature of claim 1, is realized in the CAM software (12) at the outlet thereof or in a cloud.

11. The method according to one of the previous claims, **characterized in that** the objects to be produced are produced with support structures and a comparison of the pixels of one layer with the pixels of the next layer is performed as to whether in the next layer there is an unconnected component region of pixels to be printed which was not yet present in the previous layer, and **in that** in such a case a signal (22) is output.

12. The method according to claim 11, **characterized in that**, when the signal (22) is generated on a display device, a warning is issued regarding missing support structures.

13. The method according to one of claims 1 to 10, **characterized in that** the objects to be produced are produced with support structures and a comparison of the number of pixels of one layer in the support structure with the number of pixels of the previous layer and the previous layers is performed in the support structure, and **in that** a signal is output when the result of the comparisons reveals that there is no increase in the number of pixels per layer over a predetermined number of layers, and thus no increase in area occurs that exceeds a given level.

## Revendications

1. Procédé de contrôle de plausibilité pour des dispositifs de fabrication additive, avec des données d'entrée générées au moyen d'un logiciel de FAO, qui se présentent sous la forme de données graphiques, qui sont reproduites sous la forme de couches à imprimer, où chaque couche présente au moins un pixel, en particulier une pluralité de pixels, qui correspond à la région de composant à imprimer dans la couche concernée, et avec des données de sortie qui commandent le dispositif de fabrication additive pour fabriquer le composant à imprimer, **caractérisé en ce que** les données d'entrée (14) d'au moins deux couches successives sont contrôlées et la somme de tous les pixels à exposer est déterminée pour chaque couche, et **en ce qu'**un signal (22) est émis lorsque la somme des pixels, c'est-à-dire la surface d'exposition d'une couche suivante, diffère de celle de la couche précédente au moins d'un facteur prédéterminé, en particulier est supérieure au moins du facteur prédéterminé.

2. Procédé selon la revendication 1, **caractérisé en ce qu'**un signal (22) est émis lorsque la somme de tous les pixels d'exposition de la première couche est nulle ou inférieure à une valeur prédéterminée.

3. Procédé selon la revendication 1 ou 2, **caractérisé en ce que** le procédé est mis en œuvre dans un dispositif de fabrication additive (20) et est appliqué à des objets imprimés directement, c'est-à-dire sur la plate-forme sans structure de support.

4. Procédé selon l'une quelconque des revendications précédentes, **caractérisé en ce que** la différence entre le nombre de pixels de couches successives est surveillée et un signal (22) est émis lorsque la différence en pourcentage est supérieure à une valeur prédéterminée, supérieure à une valeur positive ou inférieure à une valeur négative.

5. Procédé selon la revendication 4, **caractérisé en ce que** la valeur est une quantité.

6. Procédé selon l'une des revendications précédentes, **caractérisé en ce que** l'augmentation et/ou la diminution du nombre de pixels entre au moins deux couches déjà testées est prise en compte pour décider si le signal est émis ou non.

7. Procédé selon l'une des revendications précédentes, **caractérisé en ce que** l'écart du nombre de pixels dans des couches successives est contrôlé et qu'un signal (22) est émis lorsque l'écart fait un saut vers le négatif, c'est-à-dire lorsqu'il passe d'un écart positif à un écart négatif, en particulier nettement différent de zéro.

8. Procédé selon l'une des revendications précédentes, **caractérisé en ce que** le signal (22) est affiché sur un dispositif d'affichage et indique qu'il faut s'attendre à une erreur de construction et qu'il est recommandé de modifier l'orientation du ou des objets et de les réintroduire dans le logiciel de FAO (12).

9. Procédé selon l'une des revendications précédentes, **caractérisé en ce que** les caractéristiques selon la revendication 1 sont réalisées dans un algorithme et l'algorithme est réalisé dans le logiciel de commande pour un dispositif de fabrication additive (20).

10. Procédé selon l'une des revendications précédentes, **caractérisé en ce qu'**un algorithme, selon la caractéristique distinctive de la revendication 1, est réalisé dans le logiciel de FAO (12) à la sortie de celui-ci ou dans un cloud.

11. Procédé selon l'une quelconque des revendications précédentes, **caractérisé en ce que** les objets à générer sont générés avec des structures de support et **en ce qu'**une comparaison des pixels d'une couche avec les pixels de la couche suivante est effectuée pour déterminer s'il existe dans la couche suivante une région de composants non connectés de pixels à imprimer qui n'était pas encore présente dans la couche précédente et **en ce que**, dans un tel cas, un signal (22) est émis.

12. Procédé selon la revendication 11, **caractérisé en ce que**, lors de la génération du signal (22), un avertissement est émis sur un dispositif d'affichage concernant l'absence de structures de support.

13. Procédé selon l'une des revendications 1 à 10, **caractérisé en ce que** les objets à générer sont générés avec des structures de support et **en ce qu'**une comparaison du nombre de pixels d'une couche dans la structure de support avec le nombre de pixels de la couche précédente et des couches précédentes dans la structure de support est effectuée, et **en ce qu'**un signal est émis lorsque le résultat des comparaisons montre que, sur un nombre prédéterminé de couches, il n'y a pas d'augmentation du nombre de pixels par couche, et donc pas d'augmentation de surface, qui dépasse une mesure prédéterminée.
